(19) Europäisches Patentamt
European Patent Office
Office européen des brevets

(11) EP 2 642 633 A1

(12) EUROPEAN PATENT APPLICATION
published in accordance with Art. 153(4) EPC

(43) Date of publication:
25.09.2013 Bulletin 2013/39

(51) Int Cl.:
H02J 7/35 (2006.01)     H01M 10/44 (2006.01)
H01M 10/48 (2006.01)    H02J 3/32 (2006.01)
H02J 3/38 (2006.01)

(21) Application number: 11842438.1

(22) Date of filing: 26.10.2011

(86) International application number:
PCT/JP2011/074685

(87) International publication number:
WO 2012/066915 (24.05.2012 Gazette 2012/21)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 19.11.2010 JP 2010258467

(71) Applicant: Hitachi, Ltd.
Chiyoda-ku
Tokyo 100-8280 (JP)

(72) Inventors:
• TSUCHIYA Kazutoshi
  Hitachi-shi
  Ibaraki 319-1292 (JP)
• TOMITA Taminori
  Hitachi-shi
  Ibaraki 319-1292 (JP)
• TSUYUZAKI Masao
  Tokyo 140-8572 (JP)

(74) Representative: Thesen, Michael
Beetz & Partner
Patentanwälte
Steinsdorfstraße 10
80538 München (DE)

(54) **CONTROL DEVICE FOR ELECTRICAL STORAGE DEVICE, ELECTRICAL STORAGE DEVICE, AND METHOD FOR CHARGING/DISCHARGING ELECTRICAL STORAGE DEVICE**

(57)     In a case where a distributed generation such as a solar power generation system and an electricity accumulation apparatus are introduced to the side of a customer, an electric power from the distributed generation that is charged to the electricity accumulation apparatus cannot be caused to inversely flow to a power grid (a sale of the electricity) because it cannot be determined whether the electric power charged to the electricity accumulation apparatus is the electric power that comes from the power grid or the electric power that comes from the distributed generation. In the electricity accumulation apparatus including a dedicated charge terminal that connects to the distributed generation such as the solar power generation system and a grid-dedicated discharge terminal that connects to the power grid, a grid-dedicated charge terminal that connects to the power grid and a discharge terminal for discharging to an electric load such as an electric apparatus, the distinction with respect to an electric power charged to the electricity accumulation apparatus can be made between an electric power generated by the distributed generation and an electric power generated by the power grid, by providing an electric power measurement device for each charge terminal and each discharge terminal that connect to the distributed generation, and thus charge and discharge control can be performed.

[FIG. 1]

## Description

Technical Field

The present invention relates to an apparatus for controlling an electricity accumulation apparatus, an electricity accumulation apparatus, and a method of charging and discharging an electricity accumulation apparatus.

Background Art

A recent increase in the awareness of global environment protection has drawn attention to a distributed generation such as a solar photovoltaic power generation. An inverse load flow is performed in which excessively-generated electric power, not consumed by a customer, in electric power generated by the distributed generation, inversely flows to a commercial power grid (or in short referred to as a grid). The introduction of the distributed generation has merit, because an electric power company purchases the inversely-flowing electric power by paying a predetermined unit price for it.

On the other hand, for example because the solar photovoltaic power generation varies in an amount of generated electric power according to an amount of insolation, a technology has been considered that accomplishes a stable supply of the electric power by charging an electricity accumulation apparatus, which is introduced, when the excessively-generated electric power occurs, and by discharging the electricity accumulation apparatus, conversely when the electric power is insufficient.

However, since also the electric power from the commercial power grid is stored in the electricity accumulation apparatus, it can not be determined whether the electric power stored in the electricity accumulation apparatus is the electric power from the solar photovoltaic power generation or is the electric power purchased from the commercial power grid. For this reason, as disclosed in JP- A- 2007- 209133, a technology is known in which the inverse load flow is possible with respect to the electric power generated by the solar battery, but the inverse load flow (a sale of the electric power) is prevented with respect to the electric power charged from the grid to the electricity accumulation apparatus.

Citation List

Patent Literature

[PTL 1] JP- A- 2007- 209133

Summary of Invention

Technical Problem

However, in the related art, since the inverse load flow (the sale of the electric power) is prevented with respect to the electric power from the grid charged in the electricity accumulation apparatus, the inverse load flow of the amount of generated electric power, which is charged, is not possible. For this reason, there occurs a problem in that the excessive electric power from a distributed source can not be put to effective use.

An object of the invention is to provide an apparatus for controlling an electricity accumulation apparatus, an electricity accumulation apparatus, and a method of charging and discharging an electricity accumulation apparatus, which are able to put an electric power generation from a distributed generation to effective use, in applying the electricity accumulation apparatus to the distributed generation such as a solar photovoltaic power generation.

Solution to Problem

In order to attain the object, the invention provides a configuration in which a distributed generation's share of an electric power, which is an electric power from the distributed generation, in an electric power stored in an electricity accumulation apparatus is computed to suppress the electric power discharged from the electricity accumulation apparatus to a grid to the distributed generation's share of an electric power, or to report a value of an electric power that is to inversely flow to the grid, as a value of the electric power that is suppressed to the distributed generation's share of the electric power.

Also, in order to attain the object, the invention provides a configuration provided with a charge and discharge control unit that controls charging and discharging of an electricity accumulation apparatus, a first charge terminal that connects to a distributed generation, installed to the side of a customer, a second charge terminal that is linked to a power grid, a first discharge terminal that is linked to the power grid, and a second discharge terminal that connects to an electric apparatus of the customer.

Advantageous Effects of Invention

According to the invention, an electric power generation from the distributed generation can be put to effective use in applying the electricity accumulation apparatus to the distributed generation such as the solar photovoltaic power generation.
Other objects, features and advantages of the invention can be apparent from the following descriptions of embodiments relating to the accompanying drawings, according to the invention.

Brief Description of Drawings

[Fig. 1] Fig. 1 is a block diagram illustrating a first embodiment according to the invention.
[Fig. 2] Fig. 2 illustrates one embodiment of a charge measurement device, a discharge measurement device, and a measurement value display device.
[Fig. 3] Fig. 3 illustrates one example of a display terminal device in a case of introducing a solar power generation system.
[Fig. 4] Fig. 4 is a flowchart illustrating charge and discharge control of an electricity accumulation apparatus.
[Fig. 5] Fig. 5 is a flow chart illustrating one example (distribution charge control) of the charge and discharge control.
[Fig. 6] Fig. 6 illustrates one embodiment (nighttime grid charge) of the charge and discharge control.
[Fig. 7] Fig. 7 is a block diagram illustrating a second embodiment according to the invention.

Description of Embodiments

Embodiments according to the invention is described below referring to the drawings. Moreover, the present embodiments are described that use a solar battery as a distributed generation (PV and a solar photovoltaic power generation system).

First Embodiment

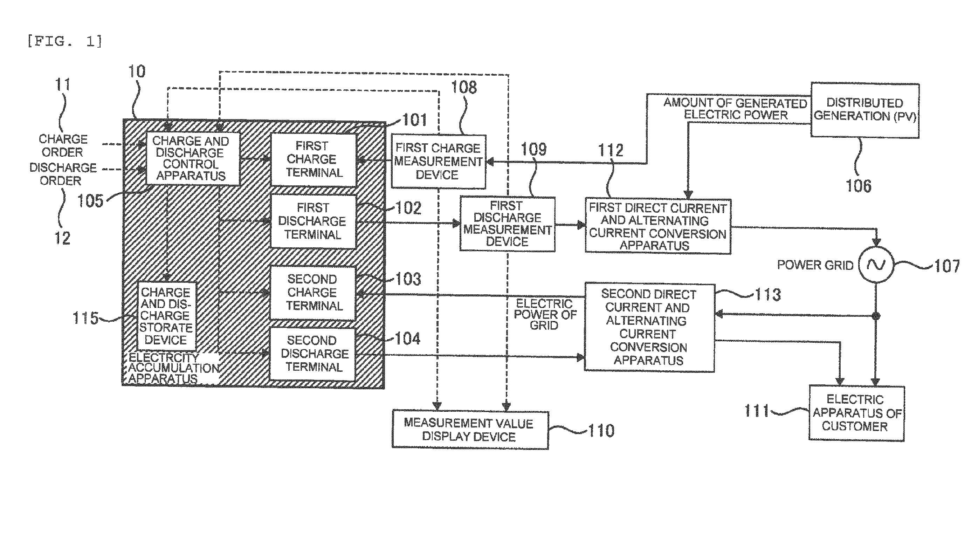

Fig. 1 is a block diagram illustrating a first embodiment of the invention. A distributed generation supporting electricity accumulation apparatus 10 illustrated in Fig. 1, is installed in a customer's house that is linked to a power grid 107, and includes a charge and discharge control apparatus 105 and a charge and discharge storage device 115, and two charge terminals and two discharge terminals. The charge and discharge control apparatus 105 and the charge and discharge storage device 115, and each discharge terminal and each charge terminal are connected to one another over a predetermined communication network. In a case of receiving a charge order 11, the charge and discharge control apparatus 105 transmits the charge order 11 to a first charge terminal 101 and a second charge terminal 103. In the same manner, in a case of receiving a discharge order 12, the charge and discharge control apparatus 105 transmits the discharge order 12 to a first discharge terminal 102 and a second discharge terminal 104. Of each charge terminal and each discharge terminal, the first charge terminal 101 is connected to a distributed generation (hereinafter referred to as a solar battery) 106 with a predetermined electric wire (an electric power cable), the first discharge terminal 102 and the second charge terminal 103 are linked to the power grid 107 with a predetermined electric wire, and the second discharge terminal 104 is connected to an electric apparatus 111 (including an electric machine and appliance, an electric communication machine and appliance and the like), possessed by a customer, with the electric wire, in the same manner. Moreover, in addition to the solar battery, the distributed generation 106 also may be, for example, a wind power generation and additionally may be a renewal energy type of electric power generation apparatus that is known as a nature type and an environment type. Moreover, the electric machine and appliance and the electric communication machine and appliance, which are possessed by the customer, are connected to one another over the predetermined communication network, and specification information on electric power consumption (a load) and on the electric machine and appliance and the electric communication machinery and appliance may be transmitted to and received from one another or transmitted to and received from the distributed generation supporting electricity accumulation apparatus 10 and the solar battery 106.
A first charge measurement device 108 is installed between the first charge terminal 101 and the solar battery 106. The first charge measurement device 108 measures a charge electric power, which is charged to the distributed generation supporting electricity accumulation apparatus 10 (hereinafter referred to as a first amount of charge), of an amount of generated electric power that is generated by the solar battery 106 (hereinafter referred to as an electric power generation) . Data on the measured first amount of charge are transmitted to a measurement value display device 110 installed in the customer's house and to the charge and discharge control apparatus 105 within the distributed generation supporting electricity accumulation apparatus 10. On the other hand, after flowing through the first charge measurement device 108, the amount of charge is charged to the distributed generation supporting electricity accumulation apparatus 10 from the first charge terminal 101.

In the same manner, a first discharge measurement device 109 and a first direct current and alternating current conversion apparatus 112 are installed between the first discharge terminal 102 and the power grid 107. The first discharge measurement device 109 measures an electric power that inversely flows from the distributed generation supporting electricity accumulation apparatus 10 to the power grid 107 (hereinafter referred to as a first amount of discharge), and successively converts an electric power, which is discharged, from a direct current to an alternating current, in the first direct current and alternating current conversion apparatus 112, and then causes the alternating-current-converted electric power to inversely flow to the power grid 107. The electric power that inversely flows in this manner is measured or calculated in a measurement device not illustrated, and the electric power is reported to an electric power company. A purchase of the electric power is made based on this report. Data on the measured first amount of discharge are transmitted to the measurement value display device 110 installed within the customer's house and to the charge and discharge control apparatus 105 within the distributed generation supporting electricity accumulation apparatus 10.

On the other hand, also the electric power that results from deducting the first amount of charge from the electric power generation that is generated by the solar battery 106 is converted from the direct current to the alternating current in the first direct current and alternating current conversion apparatus 112, and then is caused to inversely flow to the power grid 107.

With regard to an charge electric power that is charged to the distributed generation supporting electricity accumulation apparatus 10 from the power grid 107 (hereinafter referred to as a second amount of charge), the second amount of charge is converted from the alternating current into the direct current, in a second direct current/alternating current conversion apparatus 113 installed between the power grid 107 and the second charge terminal 103, and then is charged to the distributed generation supporting electricity accumulation apparatus 10 from the second charge terminal 103. An electric power, which is to be used in the predetermined electric apparatus 111 possessed by the customer (hereinafter referred to as a second amount of discharge), of an charge electric power that is charged to the distributed generation supporting electricity accumulation apparatus 10 (the first amount of charge + the second amount of charge) is discharged from the second discharge terminal 104, and then is converted from the direct current to the alternating current in the second direct current and alternating current conversion apparatus 113 and is consumed in the electric apparatus 111. On the other hand, also with regard to the electric power that is purchased from the power grid 107 (an amount of purchased electric power), the remainder of the electric power that results from excluding the second amount of charge is assigned to the electric apparatus 111, thereby leading to consumption by the electric apparatus 111. As a result, the customer can use the electric apparatus 111.

Moreover, measurement data on the first amount of charge and the second amount of charge and measurement data on the first amount of discharge and the second amount of discharge, which are transmitted to the charge and discharge control apparatus 105, are stored in the charge and discharge storage device 115. The charge and discharge storage device 115 uses one of recordable mediums such as a HDD, a CD- RAM, a DVD- RAM, a flash memory and a Blue- Ray.

Furthermore, data communication between the first charge measurement device 108 and the first discharge measurement device 109, and between the measurement value display device 110 and the charge and discharge control apparatus 105 is performed over the predetermined communication network, and the communication network is for wired communication or wireless communication such as ADSL or optical communication. In addition to a dedicated terminal monitor, a PC display, a television, or a mobile device such as a mobile phone, may be used as the measurement value display device 110.

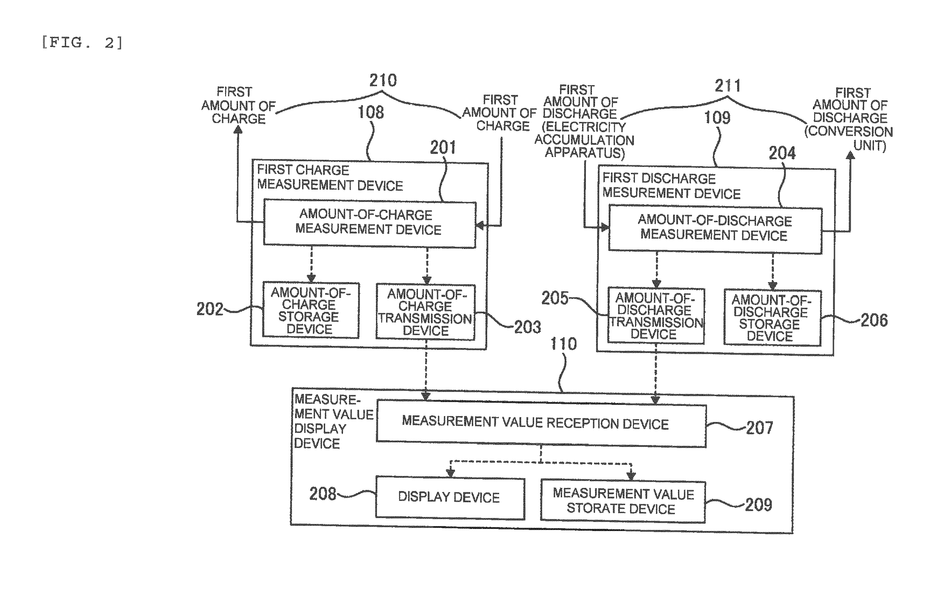

Next, basic configurations of the first charge measurement device 108 and the first discharge measurement device 109 are described referring to Fig. 2. Fig. 2 is a block diagram illustrating the basic configurations of the first charge measurement device 108 and the first discharge measurement device 109.

The first charge measurement device 108 is configured to include an amount-of-charge measurement device 201, an amount-of-charge storage device 202, and an amount-of-charge transmission device 203, and measures a first amount of charge 210 in a case where the electric power (the first amount of charge) 210, charged to the distributed generation supporting electricity accumulation apparatus 10, in the electric power generation that is generated by the solar battery 106, flows through the amount-of-charge measurement device 201. Measurement data (numerical values) on the measured first amount of charge 210 are transmitted to the amount-of-charge storage device 202 and the amount-of-charge transmission device 203. The amount-of-charge storage device 202 receives and stores the measurement data on the first amount of charge 210. The amount-of-charge transmission device 203 transmits the measurement data on the first amount of charge to the measurement value display device 110 installed within the customer's house, and the measurement data on the first amount of charge 210 is received by a measurement value reception device 207 of the measurement value display device 110.

The first discharge measurement device 109 is configured to include an amount-of-discharge measurement device 204, an amount-of-discharge transmission device 205, and an amount-of-discharge storage device 206, and measures a first amount of discharge 211 in a case where the first amount of charge 211, discharged from the distributed generation supporting electricity accumulation apparatus 10, flows through the amount-of-discharge measurement device 204. The measurement data (numerical values) on the measured first amount of discharge are transmitted to the amount-of-discharge storage device 206 and the amount-of-discharge transmission device 205. The amount-of-discharge storage device 206 receives and stores the measurement data on the first amount of discharge 211. The amount-of-discharge transmission device 205 transmits the measurement data on the first amount of discharge 211 to the measurement value display device 110 installed within the customer's house, and the measurement data on the first amount of discharge is received by the measurement value reception device 207 of the measurement value display device 110.

The measurement value display device 110 is configured to include the measurement value reception device 207, a display device 208 and a measurement value storage device 209, transmits the measurement data on the first amount of charge 210 and the measurement data on the first amount of discharge 211, which are received by the measurement value reception device 207, to the display device 208, and displays the measurement data on the display device 208. Moreover, in addition to the dedicated terminal monitor, the PC display, the television, or the mobile device such as the mobile phone, may be used as the display device 208. The measurement value storage device 209 stores the measurement data on the first amount of charge 210 and the measurement data on the first amount of discharge 211. The amount-of-charge storage device 202, the amount-of-discharge storage device 206 and the measurement value storage device 209 use one of the recordable mediums such as the HDD, the CD-RAM, the DVD-RAM, the flash memory and the Blue-Ray. Furthermore, the amount-of-charge storage device 202 and the amount-of-discharge storage device 206, and the measurement value storage device 209 are smaller in storage capacity than the charge and discharge storage device 115, and removes the numerical values, beginning with the numerical value from the storage of which 24 hours have elapsed.

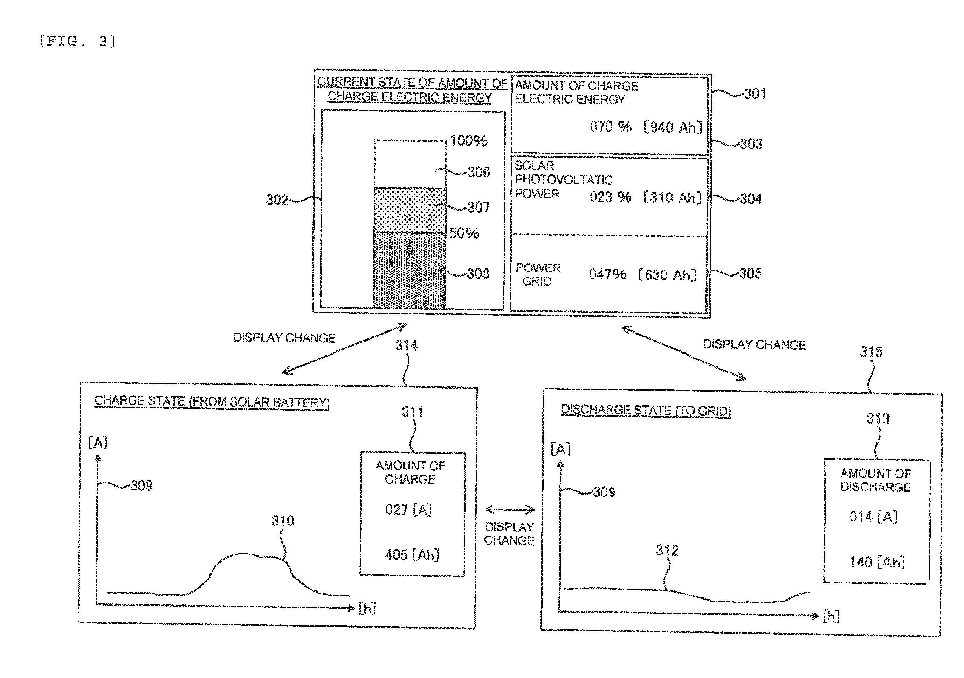

Next, Fig. 3 illustrates the measurement value display device 110 according to one embodiment in a case where the distributed generation supporting electricity accumulation apparatus 10 connects to the solar battery 106. The customer who introduces the distributed generation supporting electricity accumulation apparatus and an electric power storage system according to the invention can install the measurement value display device 110 within the customer's house and can grasp the amount of charge and the amount of discharge in the distributed generation supporting electricity accumulation apparatus 10.

A display screen 301 is configured to include a display space 302 on which to display an amount of charge [Ah] in the distributed generation supporting electricity accumulation apparatus 10 as a diagram, a display space 303 on which to display the amount of charge as a numerical value, a display space 304 which displays a ratio [%] of one part of the electric power generation in the solar battery 106 to the full capacity of the first amount of charge that is charged and the numerical value (an absolute amount) [Ah], and a display space 305 which displays the ratio [%] of one part of the amount of purchased electric power in the power grid 107 to the full capacity of the second amount of charge that is charged and the numerical value (the absolute amount) [Ah].

On the display space 302, the amount [Ah] of charged electric power in the distributed generation supporting electricity accumulation apparatus 10 is displayed as bar graphs (306, 307, and 308). The bar graph 306 displays an electric power that can be currently charged, the bar graph 307 displays the ratio [%] of the first amount of charge, and the bar graph 308 displays the ratio [%] of the second amount of charge. Moreover, according to the present embodiment, each amount of charge is displayed as the ratio [%], but may be displayed as the absolute amount [Ah] and the display may arbitrarily be changed by the customer. Furthermore, in addition to [Ah], each amount of charge may also be displayed as [kWh].

As a method for displaying on the display screen 301, the display method may arbitrarily be changed by the customer. In a case of a display screen 314, the first amount of charge (indicated by a solid line 310) that is charged from the electric power generation in the solar battery 106 is shown on a graph 309 with the electric current [A] resulting from charging along the vertical axis and time [h] along the horizontal axis. An electric current value [A] of the electric power that is charged from the current time solar battery 106 and the amount of charge [Ah] from a predetermined time are shown as numbers on a display space 311. In the same manner, in a case of a display screen 315, the second amount of charge (indicated by a solid line 312) is shown on the same graph 309, based on the amount of purchased electric power from the power grid 107. The electric current value [A] of the electric power that is charged from the current time solar battery 107 and an accumulated amount of charge [Ah] from the predetermined time are shown as numbers on a display space 313. Moreover, in addition to [Ah], a unit of the amount of charge may be shown as [kWh].

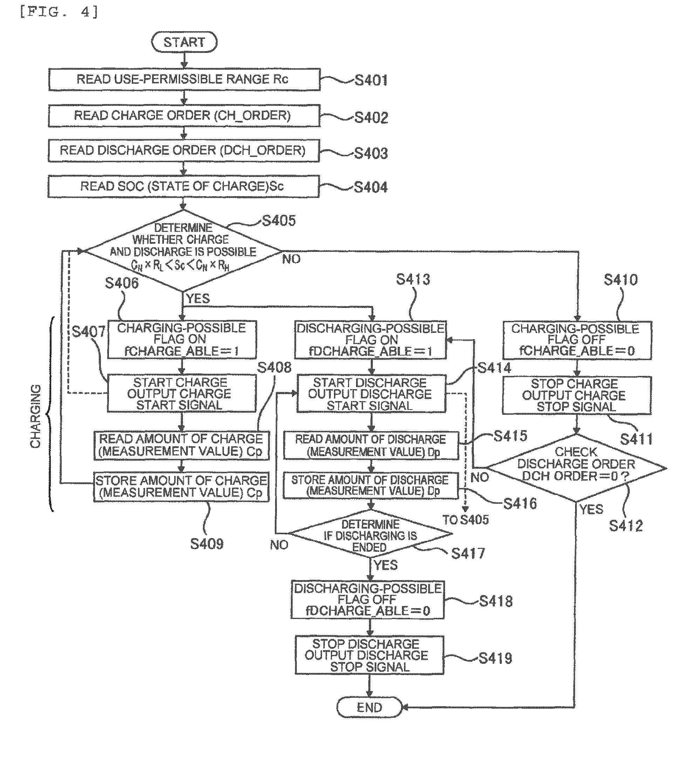

Next, charge and discharge control of the distributed generation supporting electricity accumulation apparatus 10 is described using Fig. 4. Fig. 4 is a flowchart illustrating processing details of the charge and discharge control according to one embodiment of the invention.

In processing S401, a use-permissible range Rc[Ah] (a use-permissible lower limit value $R_L$[%] and a use-permissible upper limit value $R_H$[%]) is read within which the distributed generation supporting electricity accumulation apparatus can be used, and proceeding to processing S402 takes place. In the processing S402, the charge order 11 (CH_ORDER) is read, and the proceeding to processing S403 takes place. In the processing S403, the discharge order 12 (DCH_ORDER) is read, and the proceeding to processing S404 takes place. Moreover, as the charge order 11 and the discharge order 12, for example, in addition to the charge order and the discharge order from the customer, in whose customer's house the distributed generation supporting electricity accumulation apparatus is installed, the charge order and the discharge order may be possible from a manager, responsible for the power grid, and the charge order and the discharge order associated with the charge and discharge control may be possible such as feedback control and feedforward control of the corresponding distributed generation supporting electricity accumulation apparatus. Next, in processing S404, a current state of charge (SOC) Sc[Ah] is read, and the proceeding to processing S405 takes place. In the processing S405, it is determined whether or not charging and discharging are possible, based on formulas (1), (2), and (3), from SOC read in the processing S404, the use-permissible range Rc read in the processing S401, and a rated capacity $C_N$[Ah] of the distributed generation supporting electricity accumulation apparatus.

$$C_N \times R_L < Sc < C_N \times R_H \quad \dots \quad (1)$$

(i)

$$Sc < C_N \times R_H: \text{ charging is possible } \dots \quad (2)$$

(ii)

$$C_N \times R_L < Sc: \text{ discharging is possible } \dots (3) - 1$$

(iii)

$$0 < Sc(pv): \text{ discharging is possible } \dots (3) - 2$$

In the processing S405, in a case where a charging-possible condition expressed by the formula (2) is met, it is determined that the charging is possible and the proceeding to processing S406 takes place. In the processing S406, a charging-possible flag is set to ON (fCHarge_ABLE = 1) and the electricity accumulation apparatus 10 is set to a charging-possible state. Next, in processing S407, the charging starts and then the proceeding to processing S408 takes place. Moreover, in a case where the electric power, generated by the charging in the distributed generation, is charged through the first charge terminal 101, a charge start signal is output to the first charge measurement device 108, and the first charge measurement device 108 measures an amount of charge Cp[Ah].

Next, in the processing S408, the amount of charge Cp measured by the first charge measurement device 108 is read by the charge and discharge control apparatus 105, and the proceeding to processing S409 takes place. In the processing S409, the amount of charge Cp is stored by the charge and discharge storage device 115, and returning to the processing 405 takes place. Moreover, in a case where the electric power from the power grid 107 is charged through the second charge terminal 103 to which the charge measurement device is not attached, the returning to the processing S405 takes place without performing the processing S408 and the processing S409 (a flow indicated by a dotted line).

On the other hand, in the processing S405, in a case where a discharging-possible condition expressed by both of the two formulas, the formulas (3) -1 and (3) -2, is met, it is determined that the discharging is possible, and the proceeding to processing S413 takes place. At this point, Sc (pv) is a solar battery's share of the electric power generation in the state of charge (SOC) Sc, and is a difference $(\Sigma\ Cp - \Sigma\ Dp)$ between an accumulately-computed value $(\Sigma\ Cp)$ of the amounts of charge Cp[Ah] in the first charge measurement device 108 and the accumulately-computed value $(\Sigma\ Dp)$ of the amounts of discharge Dp[Ah] in the first discharge measurement device 109. The corresponding accumulately-computed value is computed at a predetermined period and is stored in the charge and discharge storage device 115.

The formula (3)-2 shows that the solar battery 106's share of the electric power generation in the state of charge (SOC) is zero or more. That is, in a case where the electric power generation (the accumulately-computed value) in the solar battery 106 is greater than the amount of discharge (the accumulately-computed value) to the commercial power grid 107, the discharging to the power grid to the extent exceeding this is not performed.

Moreover, the condition expressed by the formula (3)- 2 can be excluded. That is, the electric power, greater than the electric power generation in the solar battery 106 can be discharged to the commercial power grid 107. However, in this case, the electric power that is a target for the charging is defined as an upper limit on the electric power generation in the solar battery 106. This computation is performed by the charge and discharge control apparatus 105 and is reported to the electric power company.

In the processing S413, a discharging-possible flag is set to ON (fDCHARGE_ABLE = 1) and the electricity accumulation apparatus 10 is set to a discharging-possible state. Next, in processing S414, the discharging starts, and then the proceeding to processing S415 takes place. Moreover, in a case where the discharging is discharged from the first discharge terminal 102 that is connected to the first discharge measurement device 109, a discharge start signal is output to the first discharge measurement device 109, and the first discharge measurement device 109 measures the amount of discharge Dp[Ah]. Next, in the processing S415, the amount of discharge Dp measured by the first discharge measurement device 109 is read by the charge and discharge control apparatus 115, and the proceeding to processing S416 takes place. In the processing S416, the amount of discharge Dp is stored in the charge and discharge storage device 115, and the proceeding to processing S417 takes place. Moreover, in a case where the electric power discharged to an electric apparatus installed in the customer's house is consumed from the second discharge terminal 104 to which the discharge measurement device is not attached, the returning to the processing S405 takes place without performing the processing S415 and the processing S416 (a flow indicated by a dotted line).

Next, in the processing S417, it is determined whether or not the discharging ends using the formula (4), based on the charging state Sc read in the processing S404, the amount of charge Cp read in the processing S408, and the amount of discharge Dp read in the processing S415. $(Sc + Cp)- Dp \le C_N \times R_L \ ... \ (4)$

In the processing S417, in a case where the condition for determining the ending of the discharging, expressed by the formula (4), is met, the proceeding to processing S418 takes place. In the processing S418, the discharging-possible flag is set to OFF (fDCHARGE_ABLE = 0). Next, in processing S419, a discharging stop signal is output to the charge and discharge control apparatus 105 and discharge control is ended. In the processing S417, in a case where the condition for determining the ending of the discharging, expressed by the formula (4), is not met, it is determined that the continuous discharging is possible, and that returning to the processing S414 takes place to perform the continuous discharging.

On the other hand, in the processing S405, in a case where the charging-possible condition, expressed by the formula (2), is not met, it is determined that the electric power can not be charged to the distributed generation supporting electricity accumulation apparatus, and the proceeding to the processing S410. In the processing S410, the charging-possible flag is set to OFF (fCHARGE_ABLE = 0). Next, in processing S411, a charging stop signal is output to the charge and discharge control apparatus 105 and thus charge control is ended and the proceeding to processing S412 takes place. In the processing S412, the discharge order is checked again, and in a case where the discharge order 12 is not present, or is cancelled (DCH_ORDER = 0), the charge and discharge control is ended. In the processing S412, in a case where the discharge order 12 is present (DCH_ORDER = 1), the proceeding to processing S413 takes place, and the discharging control is performed based on the discharge control flow.

Moreover, in the processing S405, in a case where the formula (2) and the formula (3) are both valid, the processing S406 to the processing S409, and the processing S413 to the processing to S419 can be performed at the same time in terms of time, and in such a case the discharging is performed while the charging is performed. In addition to Ah (ampere hour), the unit of the electric power that is charged and discharged may be in kWh (kilowatt hour) .

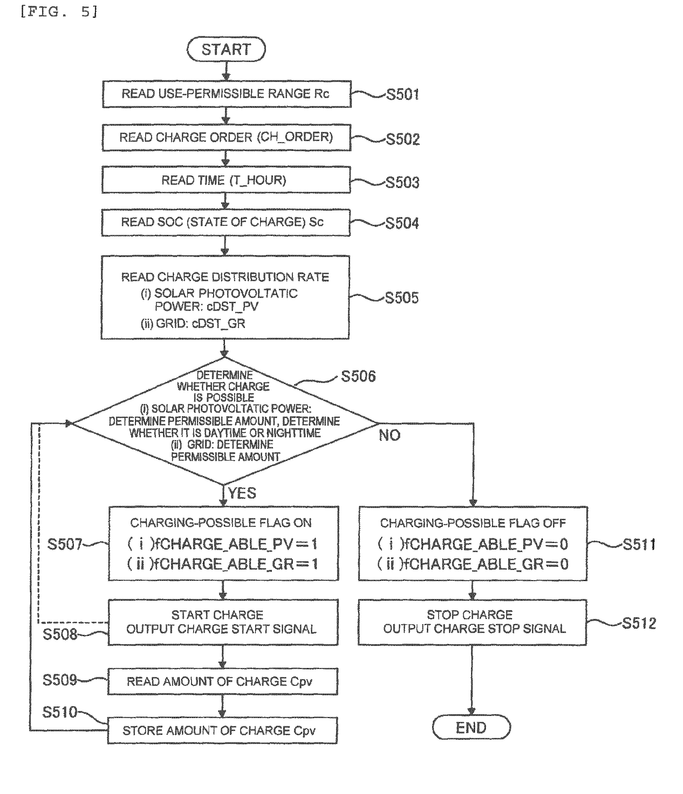

Next, the charge and discharge control of the distributed generation supporting electricity accumulation apparatus 10 is described using Fig. 5. Fig. 5 is a flowchart illustrating the processing details of charge and discharge distribution control according to one embodiment of the invention. In processing S501, the use- permissible range Rc [Ah] (the use- permissible lower limit value $R_L$ [%] and the use- permissible upper limit value $R_H$ [%] ) is read within which the distributed generation supporting electricity accumulation apparatus can be used, and the proceeding to processing S502 takes place. In the processing S502, the charge order (CH_ ORDER) is read, and the proceeding to processing S503 takes place. In the processing S503, time (T_ HOUR) is read, and the proceeding to processing S504 takes place. Moreover, the time (T_ HOUR) is in 24 hours units (every hour from 0 to 23) . Next, in the processing S504, the current state of charge (SOC) Sc [Ah] is read, and the proceeding to processing S505 takes place. In the processing S505, a charge distribution rate cDST_ PV indicating a ratio of the electric power [Ah] that is charged from the distributed generation (hereinafter referred to as the solar battery) and a charge distribution rate cDST_ GR indicating the ratio of the electric power [Ah] that is charged from the power grid are read, and the proceeding to processing S506 takes place. In the processing S506, it is determined whether or not it is daytime, using a formula (5), based on the time T_ HOUR and real time that are read in the processing S503. Furthermore, it is determined whether or not the charging from the solar battery is possible, using a formula (6), based on the use- permissible range Rc and the rated capacity $C_N$ that are read in the processing S501 and on the state of charge (SOC) Sc that is read in the processing S504. In the same manner, it is determined from the formula (6) ' whether or not the charging from the power grid is possible.

$$cT\_AM \leq T\_HOUR \leq cT\_PM \quad ... \quad (5)$$

$$Cpv < Cap \quad ... \quad (6)$$

$$Cgr < Cag \quad ... \quad (6)'$$

In the formulas, cT_AM represents a daytime start threshold value, cT_PM represents a nightime start threshold value, and time is represented with 24 hour units (with numbers every hour from 0 to 23). Furthermore, Cpv is the amount of charge [Ah] from the solar battery, and is a measurement value measured by the first charge measurement device 108, and Cap is the possible amount of charge [Ah] that is the solar battery's share and is computed using a formula (7). Cgr is the amount of charge [Ah] from the power grid and is computed using a formula (8) when the amount of charge after the charging start is defined as Sc', and Cag is the possible amount of charge [Ah] from the power grid and is computed using a formula (9).

$$Cap = Cabl \times cDST\_PV \quad ... \quad (7)$$

$$Cgr = Sc' - (Cpv + Sc) \quad ... \quad (8)$$

$$Cag = Cabl \times cDST\_GR \quad ... \quad (9)$$

In the formulas, Cabl is the possible amount of charge [Ah] and is computed using a formula (10).

$$Cabl = Cmax - Sc \quad ... \quad (10)$$

Cmax is a charging-possible upper limit value [Ah] and is computed using a formula (11).

$$Cmax = C_N \times R_H \quad ... \quad (11)$$

In a case where the amount of generated electric power generated by the solar battery is charged, when the formulas (5) and the formula (6) are valid at the same time in the processing S506, it is determined that the amount of generated electric power generated by the solar battery can be charged and the proceeding to processing S507 takes place. In the processing S507, a flag indicating that the charging is possible from the solar battery is set to ON (fCHARGE_ ABLE_PV = 1). Furthermore, with regard to the charging from the power grid, in a case where the formula (6)' is valid in the processing S506, it is determined that the electric power from the power grid can be charged and the proceeding to the processing 507 takes place. In the processing S507, a flag indicating that the charging is possible from the power grid is set to ON (fCHARGE_ABLE_GR = 1).

Next, in processing S508, the charging starts and then the proceeding to processing S509 takes place. Moreover, in a case where the amount of generated electric power, generated by the solar battery, is charged from the first charge terminal 101 to the electricity accumulation apparatus 10, the charge start signal is output to the first charge measurement device 108, and the first charge measurement device 108 measures an amount of charge Cpv [Ah] .

Next, in the processing S509, the amount of charge Cpv measured by the first charge measurement device 108 is read  by the charge and discharge control apparatus 105, and the proceeding to processing S510 takes place. In the processing S510, the amount of charge Cpv is stored by the charge and discharge storage device 115, and the returning to the processing S506 takes place. Moreover, in a case where the electric power from the power grid 107 is charged through the second charge terminal 103 to which the charge measurement device is not attached, the returning to the processing S506 takes place without performing the processing S509 and the processing S510 (a flow indicated by a dotted line) .

On the other hand, in a case where the amount of generated electric power generated by the solar battery is charged, when either of the formula (5) and the formula (6) is not valid in the processing S506, it is determined that the amount of generated electric power generated by the solar battery is not charged and the proceeding to processing S511 takes place. In the processing S511, the flag indicating that the charging is possible from the solar battery is set to OFF (fCHARGE_ABLE_PV = 0). Next, in processing S512, the charging from the solar battery is stopped and charge distribution control is ended. Furthermore, in the same manner with regard to the charging from the power grid, in a case where the formula (6)' is not valid in the processing S506, it is also determined that the electric power from the power grid is not charged and the  proceeding to the processing 511 takes place. In the processing S511, the flag indicating that the charging is possible from the power grid is set to OFF (fCHARGE_ABLE_GR = 0). Next, in processing S512, the charging from the power grid is stopped and charge distribution control is ended.

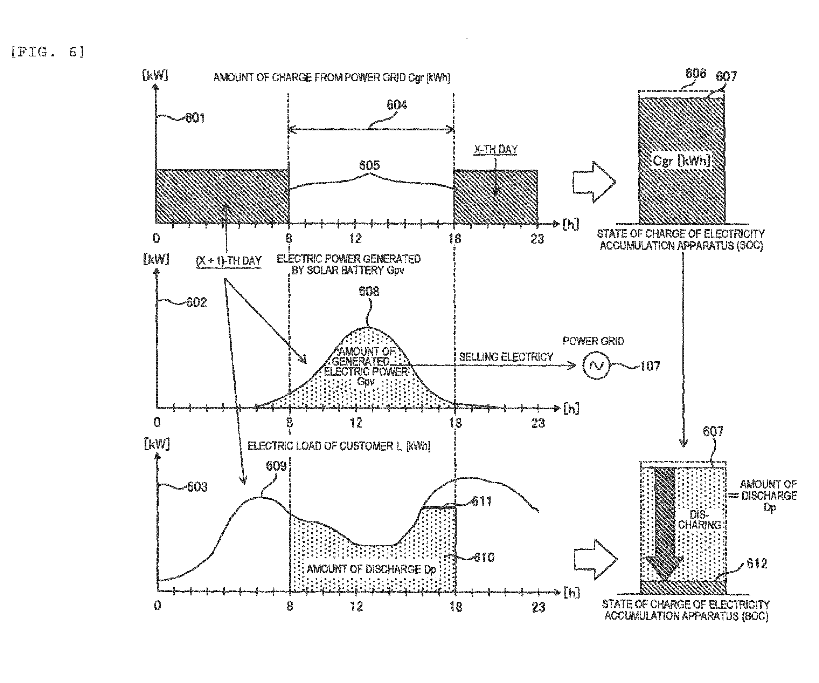

Next, one embodiment of the charge and discharge control of the distributed generation supporting electricity accumulation apparatus 10 (hereinafter referred to as the electricity accumulation apparatus) is described using Fig. 6. Fig. 6 illustrates the embodiment of a method of controlling charging and discharging in a case where the electric power from the power grid (nighttime electric power) that is charged to the electricity accumulation apparatus 10 in the night is assigned to an electric load that is consumed by the customer in the daytime, and on the other hand the electric power generated by the distributed generation inversely flows to the power grid 107 (a sale of the electricity) .

A graph 601 is a graph that represents the electric power [kW], which is charged from the power grid 107, along the vertical axis, and the time [h] along the horizontal axis. A time zone 604 is a daytime zone (hereinafter referred to as daytime), and according to the present embodiment, 10 hours from 8:00 a.m to 18:00 p.m is defined as daytime. With regard  to the setting of the daytime, the customer, or a manager responsible for the power grid, an enterpriser responsible for the electric power generation, or a manager responsible for the distributed generation arbitrarily sets the daytime in advance, or can set it to the time zone that is determined in advance seasonally or monthly. A graph 602 is a graph that represents the electric power [kW] generated by the solar battery (the distributed generation) 106 along the vertical axis, and the time [h] along the horizontal axis. A graph 603 is a graph that represents that the electric power [kW] consumed over time (hereinafter referred to as the electric power load) in the customer's house in which the corresponding electricity accumulation apparatus 10 is installed, along the vertical axis, and the time [h] along the horizontal axis.

As illustrated in the graph 601, first, the electric power from the power grid 107 is charged from 18:00 to 23:00 that is a nighttime zone (hereinafter referred to as nighttime) on the predetermined day (hereinafter referred to as the x-th day) and from 00:00 to 08:00 that is a time zone on the next day, that is, on the (x + 1) -th day (605). An amount of charge Cgr [kWh] is the sum of the electric power 605 charged from 18:00 to 23:00 on the x-th day and the electric power 605 charged from 00:00 to 08:00 on the (x + 1) -th day. The state of charge (SOC) of the electricity accumulation apparatus 10 at 8:00 on  the (x + 1) -th day becomes a state of charge 607 in which the corresponding amount of charge Cgr [kWh] is charged with respect to a maximum permissible amount 606 (a dotted line frame).

Next, when the solar battery 106 generates the electric power in a pattern of an electric power generation curved line 608 after 8: 00 on the (x + 1)- th day, the amount of generated electric power Gpv [kWh], a portion that is computed with time integration of the electric power generation curved line 608, is entirely caused to inversely flow to the power grid 107 in order to sell the electricity.

On the other hand, as illustrated in the graph 603, when the power consumption (hereinafter referred to as a load pattern) by the customer on the (x + 1) -th day is on a curved line 609, an electric power Cgr 605 charged to the electricity accumulation apparatus 10 is discharged with respect to the daytime load pattern in such a manner as to follow the corresponding load pattern 609. An amount of discharge Dp[kWh] 610 is computed with the time integration of the discharged electric power [kW]. Because at that time the basic discharge control gives priority to the discharging over the daytime 604, a maximum value 611 [kW] of the amount of discharge is set according to the state of charge (SOC) 607 at 8:00 on the (x + 1) -th day and the time zone [h], which is the daytime  604, and the electric power from the power grid 107 is assigned with respect to the load [kW] in the time zone in which the load pattern 609 exceeds the maximum value 611 [kW] of the amount of discharge (selling the electricity).

The state of charge (SOC) of the electricity accumulation apparatus 10 at 18 : 00 on the (x + 1) -th day after the discharging becomes a state of charge 612 [kWh] that results from deducting the amount of discharge Dp [KWh] from the state of charge 607.

Moreover, the maximum value 611 of the amount of discharge may not be set, and in such a case, the discharge control gives priority to the discharging that follows the load pattern 609, without giving priority to the discharging over the entire time zone of the daytime 604. For this reason, in a case where the electric power Cgr in the state of charge 607 is fully discharged in the middle of the daytime 604, the control may also be performed in such a manner that the discharge control is ended in the middle, and the electric power from the power grid 107 is assigned with respect to an electric apparatus. Second Embodiment

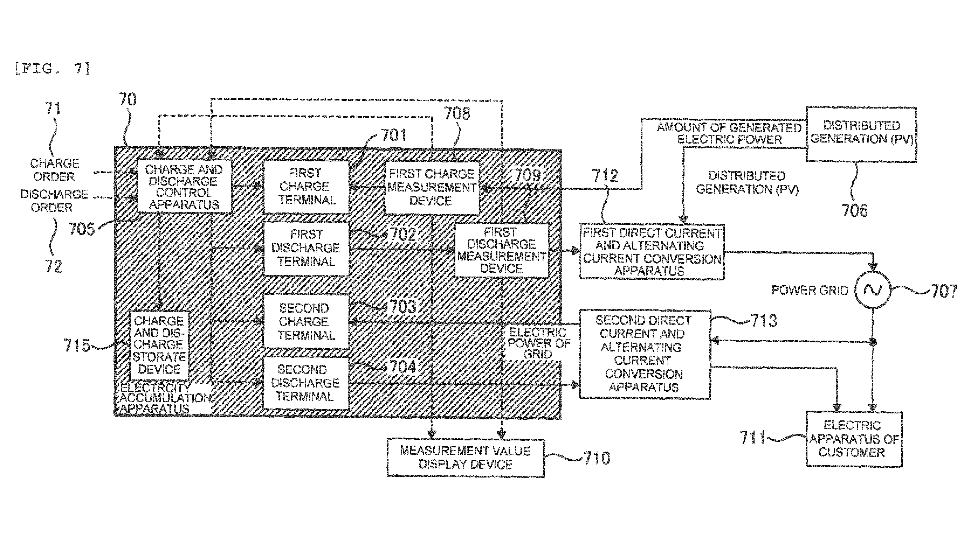

Fig. 7 is a block diagram illustrating a second embodiment of the invention. A distributed generation supporting electricity accumulation apparatus 70 illustrated in Fig. 7, is installed in a customer's house that is linked to a power grid 707, and includes a charge and discharge control apparatus 705 and a charge and discharge storage device 715, and two charge terminals and two discharge terminals, and a first charge measurement device 708 and a first discharge measurement device 709.

The charge and discharge storage device 705 and the charge and discharge storage device 715, and each charge terminal and each discharge terminal, and further the first charge measurement device 708, the first discharge measurement device 709, and a measurement value display device 710 are connected to one another over a predetermined communication network. In a case of receiving a charge order 71, the charge and discharge control apparatus 705 transmits the charge order 71 to a first charge terminal 701 and a second charge terminal 703. In the same manner, in a case of receiving a discharge order 12, the charge and discharge control apparatus 705 transmits the discharge order 72 to a first discharge terminal 702 and a second discharge terminal 704. Of each charge terminal and each discharge terminal, the first charge terminal 701 is connected to a distributed generation (hereinafter referred to as a solar battery) 706 with a predetermined electric wire (an electric power cable), the first discharge terminal 702 and the second charge terminal 703 are linked to the power grid 707 with a predetermined electric wire, and the second discharge terminal 704 is connected to an electric apparatus 711 (including an electric machine and appliance, an electric communication machinery and appliance and the like), possessed by a customer, with the electric wire, in the same manner. Moreover, the electric machine and appliance and the electric communication machinery and appliance, which are possessed by the customer, are connected to one another over the predetermined communication network, and specification information on electric power consumption (a load) and on the electric machine and appliance and the electric communication machinery and appliance may be transmitted to and received from one another or transmitted to and received from the distributed generation supporting electricity accumulation apparatus 70 and the solar battery 706.

The first charge measurement device 708 is connected between the first charge terminal 701 and the solar battery 706 with a predetermined electric power cable. The first charge measurement device 708 measures an amount of charge, which is charged to the distributed generation supporting electricity accumulation apparatus 70 (hereinafter referred to as a first amount of charge), of an amount of generated electric power that is generated by the solar battery 706 (hereinafter referred to as an electric power generation). Data on the measured first amount of charge are transmitted to a measurement value display device 710 installed in the customer's house and to the charge and discharge control apparatus 705 within the distributed generation supporting electricity accumulation apparatus 70. On the other hand, after flowing through the first charge measurement device 708, the amount of charge is charged to the distributed generation supporting electricity accumulation apparatus 70 from the first charge terminal 701.

In the same manner, the first discharge measurement device 709 and a first direct current and alternating current conversion apparatus 712 are connected between the first discharge terminal 702 and the power grid 707 with a predetermined electric power cable. The first discharge measurement device 709 measures an electric power that inversely flows from the distributed generation supporting electricity accumulation apparatus 70 to the power grid 707 (hereinafter referred to as a first amount of discharge), and successively converts an electric power, which is discharged, from a direct current to an alternating current, in the first direct current and alternating current conversion apparatus 712, and then causes the alternating-current-converted electric power to inversely flow to the power grid 707. Data on the measured first amount of discharge are transmitted to the measurement value display device 710 installed within the customer's house and to the charge and discharge control apparatus 705 within the distributed generation supporting electricity accumulation apparatus 70.

On the other hand, also the electric power that results from deducting the first amount of charge from the electric power generation that is generated by the solar battery 706 is converted from the direct current to the alternating current in the first direct current and alternating current conversion apparatus 712, and then is caused to inversely flow to the power grid 707.

With regard to an amount of charge that is charged to the distributed generation supporting electricity accumulation apparatus 70 from the power grid 707 (hereinafter referred to as a second of charge), the second amount of charge is converted from the alternating current into the direct current, in a second direct current and alternating current conversion apparatus 713 installed and connected with a predetermined electric power cable between the power grid 707 and the second charge terminal 703, and then is charged to the distributed generation supporting electricity accumulation apparatus 70 from the second charge terminal 703. An electric power, which is to be used in the predetermined electrical apparatus 711 possessed by the customer (hereinafter referred to as a second amount of discharge), of an amount of charge that is charged to the distributed generation supporting electricity accumulation apparatus 70 (the first amount of charge + the second amount of charge) is discharged from the second discharge terminal 704, and then is converted from the direct current to the alternating current in the second direct current and alternating current conversion apparatus 713 and is consumed in the electrical apparatus 711. On the other hand, also with regard to the electric power that is purchased from the power grid 707 (an amount of purchased electric power), the remainder of the electric power that results from excluding the second amount of charge is assigned to the electric apparatus 711, thereby leading to consumption by the electric apparatus 711. As a result, the customer can use the electric apparatus 711.

Moreover, the measurement data on the first amount of charge and the second amount of charge and the measurement data on the first amount of discharge and the second amount of discharge, which are transmitted to the charge and discharge control apparatus 705, are stored in the charge and discharge storage device 715. The charge and discharge storage device 715 uses one of the recordable mediums such as the HDD, the CD- RAM, the DVD- RAM, the flash memory and the Blue- Ray.

Furthermore, the data communication between the first charge measurement device 708 and the first discharge measurement device 709, and between the measurement value display device 710 and the charge and discharge control apparatus 705 is performed over the predetermined communication network, and the communication network is for wired communication or wireless communication such as ADSL or optical communication. In addition to the dedicated terminal monitor, the PC display, the television, or the mobile device such as the mobile phone, may be used as the measurement value display device 710.

Features of the above embodiments are again described as follows. The electricity accumulation apparatus that is installed to the side of a customer includes a charge and discharge control unit that controls charging and discharging of the electricity accumulation apparatus, a first charge terminal that connects to a distributed generation, installed to the side of the customer, a second charge terminal that is linked to a power grid, a first discharge terminal that is linked to the power grid, and a second discharge terminal that connects to an electric apparatus of the customer (feature 1).

The electricity accumulation apparatus includes a first charge measurement device between the distributed generation and the first charge terminal, and a first discharge measurement device between the power grid and the first discharge terminal. The first charge measurement device includes an amount-of-charge measurement unit that measures an electric power (an amount of charge), charged to the electricity accumulation apparatus, in an amount of generated electric power generated by the distributed generation. The first discharge measurement device includes a discharge measurement unit that measures an electric power (an amount of discharge) that is discharged from the electricity accumulation apparatus (feature 2).

The first charge measurement device includes an amount-of-charge transmission unit that transmits numerical data on the measured amount of charge to a measurement value display device and the charge and discharge control unit, and the first discharge measurement device includes an amount-of-discharge transmission unit that transmits the numerical data on the measured amount of discharge to the measurement value display device and the charge and discharge control unit (feature 3).

An electric power (an amount of charge) that is charged to the electricity accumulation apparatus from an amount of generated electric power generated by the distributed generation is measured by the first charge measurement device, and then is charged to the electricity accumulation apparatus through the first charge terminal, and a second direct current and alternating current conversion apparatus converts the electric power from the power grid from alternating current electric power to direct current electric power, and then direct- current- electric- power converted electric power is charged to the electricity accumulation apparatus through the second charge terminal (feature 4) .

A distinction is made between an electric power charged from the distributed generation and an electric power charged from the power grid, in an electric power charged to the electricity accumulation apparatus, based on the numerical data on the amount of charge measured by the first charge measurement device (feature 5).

There is a feature that the electric power, charged from the distributed generation, in the electric power charged to the electricity accumulation apparatus, is discharged from the first discharge terminal, the electric power discharged (the amount of discharge) is measured in the first discharge measurement device, then the first direct current and alternating current conversion apparatus converts the measured amount of discharge from the direct current electric power to the alternating current electric power, and the alternating- current- electric- power converted electric power is discharged to the power grid (an inverse flow) (feature 6) .

The electric power, charged from the power grid, in the electric power charged to the electricity accumulation apparatus is discharged from the second discharge terminal, the electric power discharged is converted from the alternating current electric power to the direct current electric power in the second direct current and alternating current conversion apparatus, and then the direct- current- electric- power converted electric power is consumed in an electric apparatus possessed by the customer (feature 7) .

With respect to an amount of generated electric power generated by the distributed generation, the amount of generated electric power is converted by the first direct current and alternating current conversion apparatus from the direct current electric power to the alternating current electric power, and then alternating- current- electric- power converted electric power is caused to inversely flow to the power grid. At the same time, the electric power, which is charged to the electricity accumulation apparatus, and which is charged from the distributed generation, is discharged from the first discharge terminal to the power grid. As a result, the electric power that is equal to or more than an electric power that is generated by the distributed generation is caused to inversely flow to the power grid (feature 8) .

The electricity accumulation apparatus includes a measurement value reception unit that receives numerical data on an amount of charge which is transmitted from the first charge measurement device and numerical data on an amount of discharge which is transmitted from the first discharge measurement device, a measurement value storage unit that stores the numerical data on the amount of charge and the numerical data on the amount of discharge, and a measurement value display unit that displays the numerical data. The numerical data on the amount of charge measured by the first charge measurement device and the numerical data on the amount of discharge measured by the first discharge measurement device are displayed (feature 9).

The distributed generation is an electric power generation apparatus, installed to the side of the customer and includes at least one or more electric power generation system of a solar photovoltaic power generation system using solar cells, a wind power generation system, a co-generation system including a generator using gas, and a bio-mass generation system (feature 10).

The electric apparatus is an apparatus, possessed by the customer, which consumes the electric power. The electric apparatus includes at least one or more of an electric machine and appliance, an electric communication machine and appliance, an electronic applied machine and appliance, and a medical machine and appliance (feature 11).

A distinction is made between an electric power charged from the distributed generation and an electric power charged from the power grid, in an electric power charged to the electricity accumulation apparatus, based on the numerical data on the amount of charge measured by the first charge measurement device, and only the electric power charged from the distributed generation, or only the electric power generated by the distributed generation is caused to inversely flow to the power grid (feature 12).

According to the features 1 to 12 described above, it is possible to grasp the amount of generated electric power, generated by the distributed generation, which is charged to the electricity accumulation apparatus, by including the charge terminal that connects to the distributed generation, the discharge terminal that connects to a power grid, the charge terminal that connects to the power grid, and the discharge terminal for discharging to an electric power load such as the electric apparatus and by attaching an electric power meter to the charge terminal and the discharge terminal that connect to the distributed generation. Therefore, it is possible to make a distinction of the distributed generation's share of the amount of generated electric power, which comes from the distributed generation, in the electric power that is charged to the electricity accumulation apparatus and to cause the amount of generated electric power to inversely flow to the power grid (a sale of the electricity).

The above descriptions are provided with regard to the embodiments, but the invention is not limited to this, and it is apparent to a person of ordinary skill in the art that various modifications and changes are possible within the nature of the invention and the scopes of the accompanying claims.

Reference Signs List

10 DISTRIBUTED GENERATION SUPPORTING ELECTRICITY ACCUMULATION APPARATUS
106 DISTRIBUTED GENERATION (SOLAR BATTERY)
107 COMMERCIAL POWER GRID (POWER GRID)
111,711 ELECTRIC APPARATUS (ELECTRIC APPARATUS POSSESSED BY CUSTOMER)
301 DISPLAY SCREEN (MEASUREMNET VALUE DISPLAY SCREEN)
604 DAYTIME TIME ZONE (DAYTIME)
605 AMOUNT OF CHARGE [kWh] FROM POWER GRID
606 MAXIMUM AMOUNT (CAPACITY) OF CHARGE FOR ELECTRICITY ACCUMULATION APPARATUS
607 STATE OF CHARGE OF ELECTRICITY ACCUMULATION APPARATUS AFTER BEING CHARGED FROM POWER GRID
608 ELECTRIC POWER [kWh] GENERATED BY SOLAR BATTERY
609 LOAD PATTERN OF CUSTOMER
610 AMOUNT OF DISCHARGE [kWH] FROM ELECTRICITY ACCUMULATION APPARATUS

**Claims**

1. An apparatus for controlling an electricity accumulation apparatus on which an electric power from a distributed generation and a grid is stored, comprising:

   an electricity accumulation electric power computation unit that computes a distributed generation's share of an electric power that is the electric power from the distributed generation in an electric power that is charged to the electricity accumulation apparatus; and
   a discharged electric power computation unit that suppresses an electric power that is to be discharged from the electricity accumulation apparatus to the grid, to the distributed generation's share of the electric power, or reports a value of an electric power that is to inversely flow to the grid, as a value of the electric power that is suppressed to the distributed generation's share of the electric power.

2. The apparatus for controlling an electricity accumulation apparatus according to claim 1, wherein the distributed generation' share of the electric power is computed based on a measurement value obtained by a measurement device that measures an amount of charge charged from the distributed generation to the electricity accumulation apparatus.

3. The apparatus for controlling an electricity accumulation apparatus according to claim 2, wherein the distributed generation' share of the electric power is computed based on the measurement value obtained by the measurement device that measures an amount of discharge discharged from the electricity accumulation apparatus to the grid.

4. The apparatus for controlling an electricity accumulation apparatus according to claim 1, wherein the amount of charge that is charged from the grid to the electricity accumulation apparatus varies with time.

5. An electricity accumulation apparatus on which an electric power from a distributed generation and a grid is stored, comprising:

   an electricity accumulation electricity energy computation unit that computes a distributed generation's share of an electric power that is the electric power from the distributed generation in an electric power that is stored; and
   a discharged electric power computation unit that suppresses an electric power discharged to the grid to the distributed generation's share of the electric power, or reports a value of an electric power that is to inversely flow to the grid, as a value of the electric power that is suppressed to the distributed generation's share of the electric power.

6. An electricity accumulation apparatus that is installed to the side of a customer, comprising:

   a charge and discharge control unit that controls charging and discharging the electricity accumulation apparatus;
   a first charge terminal that connects to a distributed generation, installed to the side of the customer;
   a second charge terminal that is linked to a power grid;
   a first discharge terminal that is linked to the power grid; and
   a second discharge terminal that connects to an electric apparatus of the customer.

7. A method of charging and discharging an electricity accumulation apparatus, in which the charging to and the discharging from the electricity accumulation apparatus are performed, the method comprising:

   computing a distributed generation's share of an electric power that is an electric power that is stored from a distributed generation to the electricity accumulation apparatus, in an electric power that is stored from the distributed generation and an electric power that is stored from a grid; and
   reporting a value of an electric power that is to inversely flow to the grid, as a value of the electric power that is suppressed to the distributed generation's share of the electric power.

[FIG. 1]

11 CHARGE ORDER
12 DISCHARGE ORDER
105
10

106 DISTRIBUTED GENERATION (PV)
AMOUNT OF GENERATED ELECTRIC POWER
112
109
108
101 FIRST CHARGE MEASUREMENT DEVICE
102 FIRST DISCHARGE MEASUREMENT DEVICE
103
104
107 POWER GRID
113
111 ELECTRIC APPARATUS OF CUSTOMER
FIRST DIRECT CURRENT AND ALTERNATING CURRENT CONVERSION APPARATUS
SECOND DIRECT CURRENT AND ALTERNATING CURRENT CONVERSION APPARATUS
ELECTRIC POWER OF GRID
110 MEASUREMENT VALUE DISPLAY DEVICE
CHARGE AND DISCHARGE CONTROL APPARATUS
FIRST CHARGE TERMINAL
FIRST DISCHARGE TERMINAL
SECOND CHARGE TERMINAL
SECOND DISCHARGE TERMINAL
115 CHARGE AND DIS-CHARGE STORATE DEVICE
ELECTRICITY ACCUMULATION APPARATUS

14

[FIG. 2]

FIRST AMOUNT OF CHARGE — 210 / 108

FIRST AMOUNT OF CHARGE

FIRST AMOUNT OF DISCHARGE (ELECTRICITY ACCUMULATION APPARATUS)

211 / 109

FIRST AMOUNT OF DISCHARGE (CONVERSION UNIT)

FIRST CHARGE MEASUREMENT DEVICE — 201

AMOUNT-OF-CHARGE MEASUREMENT DEVICE

202 — AMOUNT-OF-CHARGE STORAGE DEVICE

AMOUNT-OF-CHARGE TRANSMISSION DEVICE — 203

FIRST DISCHARGE MESUREMENT DEVICE — 204

AMOUNT-OF-DISCHARGE MEASUREMENT DEVICE

205 — AMOUNT-OF-DISCHARGE TRANSMISSION DEVICE

AMOUNT-OF-DISCHARGE STORAGE DEVICE — 206

MEASUREMENT VALUE DISPLAY DEVICE — 110

MEASUREMENT VALUE RECEPTION DEVICE — 207

208 — DISPLAY DEVICE

MEASUREMENT VALUE STORATE DEVICE — 209

[FIG. 3]

CURRENT STATE OF AMOUNT OF CHARGE ELECTRIC ENERGY

302

100%
306
307
50%
308

AMOUNT OF CHARGE ELECTRIC ENERGY

070 % [940 Ah]

301
303

SOLAR PHOTOVOLTATIC POWER    023 % [310 Ah]

304

POWER GRID    047% [630 Ah]

305

DISPLAY CHANGE        314

DISPLAY CHANGE        315

CHARGE STATE (FROM SOLAR BATTERY)    311

[A]

309

310

AMOUNT OF CHARGE

027 [A]

405 [Ah]

[h]

DISPLAY CHANGE

DISCHARGE STATE (TO GRID)    313

[A]

309

312

AMOUNT OF DISCHARGE

014 [A]

140 [Ah]

[h]

[FIG. 4]

START

READ USE-PERMISSIBLE RANGE Rc — S401

READ CHARGE ORDER (CH_ORDER) — S402

READ DISCHARGE ORDER (DCH_ORDER) — S403

READ SOC (STATE OF CHARGE)Sc — S404

S405 — DETERMINE WHETHER CHARGE AND DISCHARGE IS POSSIBLE $C_N \times R_L < S_C < C_N \times R_H$ — NO

YES

S406 — CHARGING-POSSIBLE FLAG ON fCHARGE_ABLE=1

S413 — DISCHARGING-POSSIBLE FLAG ON fDCHARGE_ABLE=1

S410 — CHARGING-POSSIBLE FLAG OFF fCHARGE_ABLE=0

S407 — START CHARGE OUTPUT CHARGE START SIGNAL

S414 — START DISCHARGE OUTPUT DISCHARGE START SIGNAL

STOP CHARGE OUTPUT CHARGE STOP SIGNAL

S408 — READ AMOUNT OF CHARGE (MEASUREMENT VALUE) Cp

READ AMOUNT OF DISCHARGE (MEASUREMENT VALUE) Dp — S415

S411 — CHECK DISCHARGE ORDER DCH ORDER=0 ?

STORE AMOUNT OF CHARGE (MEASUREMENT VALUE) Cp

STORE AMOUNT OF DISCHARGE (MEASUREMENT VALUE) Dp

NO

S416

TO S405

YES

S412

CHARGING

S409

DETERMINE IF DISCHARGING IS ENDED — S417

NO

YES

DISCHARGING-POSSIBLE FLAG OFF fDCHARGE_ABLE=0 — S418

STOP DISCHARGE OUTPUT DISCHARGE STOP SIGNAL — S419

END

[FIG. 5]

```
                    ┌─────────┐
                    │  START  │
                    └────┬────┘
                         │
        ┌────────────────┴────────────────┐
        │ READ USE-PERMISSIBLE RANGE Rc    │───S501
        └────────────────┬────────────────┘
                         │
        ┌────────────────┴────────────────┐
        │ READ CHARGE ORDER (CH_ORDER)     │───S502
        └────────────────┬────────────────┘
                         │
        ┌────────────────┴────────────────┐
        │ READ TIME (T_HOUR)               │───S503
        └────────────────┬────────────────┘
                         │
        ┌────────────────┴────────────────┐
        │ READ SOC (STATE OF CHARGE) Sc    │───S504
        └────────────────┬────────────────┘
                         │
        ┌────────────────┴────────────────┐
        │ READ CHARGE DISTRIBUTION RATE    │
        │   (i) SOLAR PHOTOVOLTATIC        │───S505
        │       POWER: cDST_PV             │
        │   (ii) GRID: cDST_GR             │
        └────────────────┬────────────────┘
                         │
              ╱──────────┴──────────╲
             ╱       DETERMINE        ╲ ───S506
            ╱     WHETHER CHARGE       ╲
           ╱         IS POSSIBLE        ╲
          ╱ (i) SOLAR PHOTOVOLTATIC POWER:╲
          ╲ DETERMINE PERMISSIBLE AMOUNT, DETERMINE ╱     NO
           ╲ WHETHER IT IS DAYTIME OR NIGHTTIME ╱─────────┐
            ╲  (ii) GRID: DETERMINE   ╱                   │
             ╲  PERMISSIBLE AMOUNT   ╱                    │
              ╲──────────┬──────────╱                     │
                        │ YES                             │
        ┌────────────────┴────────────┐    ┌──────────────┴───────────────┐
        │ CHARGING-POSSIBLE FLAG ON    │    │ CHARGING-POSSIBLE FLAG OFF   │
  S507──│  (i) fCHARGE_ABLE_PV=1       │    │  (i) fCHARGE_ABLE_PV=0       │───S511
        │  (ii) fCHARGE_ABLE_GR=1      │    │  (ii) fCHARGE_ABLE_GR=0      │
        └────────────────┬────────────┘    └──────────────┬───────────────┘
                        │                                 │
        ┌────────────────┴────────────┐    ┌──────────────┴───────────────┐
        │ START CHARGE                 │    │ STOP CHARGE                  │───S512
  S508──│ OUTPUT CHARGE START SIGNAL   │    │ OUTPUT CHARGE STOP SIGNAL    │
        └────────────────┬────────────┘    └──────────────┬───────────────┘
                        │                                 │
  S509──┌────────────────┴────────────┐              ┌─────┴─────┐
        │ READ AMOUNT OF CHARGE Cpv    │              │    END    │
        └────────────────┬────────────┘              └───────────┘
                        │
  S510──┌────────────────┴────────────┐
        │ STORE AMOUNT OF CHARGE Cpv   │
        └─────────────────────────────┘
```

18

[FIG. 6]

AMOUNT OF CHARGE FROM POWER GRID Cgr [kWh]

601

604

605

X-TH DAY

0   8   12   18   23   [h]

STATE OF CHARGE OF ELECTRICITY
ACCUMULATION APPARATUS (SOC)

606  607

Cgr [kWh]

(X + 1)-TH DAY   ELECTRIC POWER GENERATED
BY SOLAR BATTERY Gpv

602

608

AMOUNT OF
GENERATED
ELECTRIC POWER
Gpv

SELLING ELECTRICY

POWER GRID

107

0   8   12   18   23   [h]

ELECTRIC LOAD OF CUSTOMER L [kWh]

603

609

611

610

AMOUNT OF DISCHARGE Dp

0   8   12   18   23   [h]

607

DIS-
CHARING

AMOUNT OF
= DISCHARGE
Dp

612

STATE OF CHARGE OF ELECTRICITY
ACCUMULATION APPARATUS (SOC)

EP 2 642 633 A1

19

[FIG. 7]

EP 2 642 633 A1

## INTERNATIONAL SEARCH REPORT

International application No.

PCT/JP2011/074685

### A. CLASSIFICATION OF SUBJECT MATTER
*H02J7/35*(2006.01)i, *H01M10/44*(2006.01)i, *H01M10/48*(2006.01)i, *H02J3/32* (2006.01)i, *H02J3/38*(2006.01)i

According to International Patent Classification (IPC) or to both national classification and IPC

### B. FIELDS SEARCHED

Minimum documentation searched (classification system followed by classification symbols)
H02J7/35, H01M10/44, H01M10/48, H02J3/32, H02J3/38

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2008-104332 A  (Idemitsu Kosan Co., Ltd.), 01 May 2008 (01.05.2008), paragraphs [0050] to [0061]; fig. 1, 2 (Family: none) | 6 |
| P,X | WO 2011/039604 A1  (Panasonic Electric Works Co., Ltd.), 07 April 2011 (07.04.2011), entire text; all drawings & JP 2011-83058 A | 1-5,7 |
| A | JP 2009-033797 A  (Fujipream Corp.), 12 February 2009 (12.02.2009), paragraph [0006]; fig. 1 (Family: none) | 1,5,7 |

☐ Further documents are listed in the continuation of Box C.  ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| | |
|---|---|
| Date of the actual completion of the international search<br>06 January, 2012 (06.01.12) | Date of mailing of the international search report<br>17 January, 2012 (17.01.12) |
| Name and mailing address of the ISA/<br>Japanese Patent Office | Authorized officer |
| Facsimile No. | Telephone No. |

Form PCT/ISA/210 (second sheet) (July 2009)

**EP 2 642 633 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007209133 A